Europäisches Patentamt

European Patent Office

Office européen des brevets

(19)

(11) EP 0 600 794 B1

(12) FASCICULE DE BREVET EUROPEEN

(45) Date de publication et mention
de la délivrance du brevet:
06.10.1999 Bulletin 1999/40

(51) Int Cl.$^6$: **G01R 33/06**, H01F 10/08

(21) Numéro de dépôt: **93402914.1**

(22) Date de dépôt: **01.12.1993**

(54) **Structure magnétique multicouches à forte magnétorésistance et procédé de fabrication de la structure**

Magnetische Mehrschichtstruktur mit Riesenmagnetowiderstand und Verfahren zur Herstellung dieser Struktur

Magnetic multilayer structure with giant magnetoresistance and manufacture of this structure

(84) Etats contractants désignés:
**BE CH DE GB IT LI NL**

(30) Priorité: **03.12.1992 FR 9214557**

(43) Date de publication de la demande:
**08.06.1994 Bulletin 1994/23**

(73) Titulaire: **COMMISSARIAT A L'ENERGIE ATOMIQUE**
**75015 Paris (FR)**

(72) Inventeurs:
- **Rodmacq, Bernard**
  **F-38420 Le Versoud (FR)**
- **Pierrot, André**
  **F-38360 Sassenage (FR)**
- **Gerard, Philippe**
  **F-38330 Saint Ismier (FR)**
- **Mouchot, Jean**
  **F-38000 Grenoble (FR)**

(74) Mandataire: **Dubois-Chabert, Guy et al**
**c/o BREVATOME**
**3, rue du Docteur Lanceraux**
**75008 Paris (FR)**

(56) Documents cités:
**EP-A- 0 526 044**

- **PHYSICAL REVIEW, B. CONDENSED MATTER, vol.43, no.1, Janvier 1991, NEW YORK US pages 1297 - 1300, XP228681 B.DIENY E.A. 'Giant magnetoresistance in soft ferromagnetic multilayers'**
- **REVUE DE PHYSIQUE APPLIQUEE, vol.25, no.10, Octobre 1990, PARIS FR pages 971 - 976, XP161600 F.NGUYEN-VAN-DAU E.A. 'Recent advances in molecular deam epitaxy of metallic multilayers and superlattices'**

# Description

La présente invention a pour objet un procédé de fabrication d'une structure magnétique multicouche métallique à forte magnétorésistance.

Dans la suite de ce texte, cette structure sera désignée par le terme SMMM.

Cette structure est plus particulièrement destinée à la réalisation de capteurs tels que les capteurs de champs faibles, les têtes d'enregistrement magnétique (lecture magnétorésistive), les décodeurs angulaires ou linéaires pour la restitution d'informations codées sous forme magnétique dans un milieu quelconque tel que bande, ticket, carte, disque magnétiques, etc.

Aussi, l'invention contribue à la réalisation de capteurs magnétiques.

La SMMM de l'invention peut aussi être utilisée pour la réalisation de guides de flux magnétiques.

Les SMMM connues sont formées d'un empilement de couches métalliques magnétiques séparées par des couches métalliques non-magnétiques, dans lesquelles l'épaisseur des couches non-magnétiques est telle qu'un couplage anti-ferromagnétique s'établisse entre les couches magnétiques. Sous l'effet d'un champ magnétique appliqué à la structure, la rotation de l'état anti-parallèle à l'état parallèle des aimantations de chacune des couches magnétiques s'accompagne d'une diminution de la résistance électrique de la structure : c'est l'effet magnétorésistif.

Ainsi, on peut en mesurant la résistance de la structure, mesurer un champ magnétique et réciproquement mesurer une résistance électrique en mesurant un champ magnétique.

En effet, on définit le champ magnétique à saturation Hs comme étant le champ magnétique appliqué à la structure qui est suffisant pour orienter parallèlement entre elles l'aimantation de chacune des couches magnétiques, initialement anti-parallèle en l'absence de champ.

Dans une SMMM parcourue par un courant uniforme et présentant des couplages anti-ferromagnétiques, on définit la magnétorésistance MR comme étant le rapport

$$\Delta\rho/\rho = \frac{[\rho(H=0) - \rho(H=Hs)]}{\rho(H=0)}$$

où H représente la valeur du champ appliqué ; $\rho(H=0)$ est la résistivité de la SMMM en champ nul et $\rho(H=Hs)$ sa résistivité lorsqu'elle est en présence d'un champ magnétique égal au champ à saturation.

En outre, $\Delta\rho/\rho = \Delta R/R$, avec R représentant la résistance de la SMMM.

La sensibilité $\alpha$ de la structure magnétorésistive et donc celle d'un capteur à effet magnétorésistif sont définies par la variation de la magnétorésistance, obtenue par application d'un champ magnétique unitaire ; elle satisfait à la relation :

$$\alpha = (d(\Delta R/R)/dH)_{H<Hs}.$$

En outre, l'épaisseur des couches magnétiques et non-magnétiques doit être finement ajustée afin d'obtenir le maximum de magnétorésistance, c'est-à-dire une valeur de $\Delta R/R$ la plus élevée possible, ceci pour un champ à saturation le plus faible possible.

Des capteurs à effet magnétorésistif à structure multicouche sont -en particulier décrits dans les documents EP-A- 442 407 (réf. 1), FR-A-2 648 942 (réf. 2) et US-A-4 949 039 (réf. 3).

Des exemples de réalisation de structures multicouches magnétorésistives sont, par ailleurs, décrits dans les documents :

- Physical Review B, vol. 44, n°10, septembre 1991, "Oscillatory interlayer exchange and magnetoresistance in Fe/Cu multilayers" de F. Petroff et al., p. 5355-5357 (réf. 4) ;
- Appl. Phys. Lett. 60(4), janvier 1992, "Oscillations in giant magnetoresistance and antiferromagnetic coupling in $(Ni_{81}Fe_{19}/Cu)_n$ multilayers", de S.S P. Parkin, p. 512-514 (réf. 5) ;
- Journal of Magnetism and Magnetic Materials 94 (1991), L1-L5, "Oscillatory interlayer coupling and giant magnetoresistance in Co/Cu multilayers" de D.H. Mosca et al. (réf.6) ;
- Physical Review Letters, vol. 66, n°16, avril 1991, "Oscillaroty magnetic exchange coupling through thin copper layers" de S.S.P. Parkin et al., p. 2152-2155 (réf. 7) ;
- Journal of the Physical Society of Japan, vol. 60, n°9, septembre 1991, p. 2827-2830, "Giant magnetoresistance and oscillatory magnetic coupling of evaporated and MBE-grown Co/Ag multilayers" de S. Araki et al. (réf. 8) ;
- J. Appl. Phys. 70(8), octobre 1991, "X-ray diffraction study of silver-nickel superlattices" de B. Rodmacq, p. 4194-4201 (réf. 9) ;
- IEEE Transactions on magnetics, vol. 28, n°5, septembre 1992, "Giant magnetoresistance in Ni-Fe/ Cu multilayers formed by ion beam sputtering" de R. Nakatani et al., p. 2668-2670 (réf. 10) ;
- Appl. Phys. Lett. 61(15), octobre 1992, "Co/Ag multilayer film : role of annealing on the magnetic properties" de L.F. Schelp et al., p. 1858-1860 (réf. 11);
- Phys. Rev. B, 43 (1991) 12.97.

Les matériaux magnétiques principalement utilisés dans les structures multicouches sont le fer (voir références 1 à 4, 7), les alliages de fer et de nickel Fe-Ni (voir références 3, 5, 10) ; le cobalt (voir références 1, 6 à 8, 11) ; le nickel (voir référence 9).

Les matériaux non-magnétiques utilisés dans les structures multicouches magnétiques doivent posséder une conductivité électrique élevée. Aussi, on utilise le plus souvent le cuivre (voir les références 1, 4 à 7, 10). On a aussi envisagé le chrome (références 2, 4), l'or (voir références 3, 5), le ruthénium (voir références 4, 6) et plus récemment l'argent (voir références 8, 9 et 11).

Certaines SMMM présentent une hystérésis magnétique, entraînant pour un capteur comportant ces structures, des possibilités d'instabilité lors de fortes perturbations magnétiques extérieures. Ceci est notamment le cas pour les structures multicouches des références 6 et 11.

En outre, dans cette application particulière de capteurs, les structures magnétiques multicouches vont nécessairement subir, lors des étapes ultérieures de fabrication des capteurs, des cycles thermiques pouvant aller jusqu'à 300°C.

En effet, la réalisation des capteurs nécessite l'empilement de couches de natures différentes, isolantes, conductrices, magnétiques, etc. déposées à des températures souvent élevées sur la SMMM.

Or, ces cycles thermiques entraînent, pour les structures actuellement connues, une diminution de la magnétorésistance (voir références 5 et 7), ainsi qu'une stabilité ou une augmentation du champ magnétique à saturation (voir référence 5) . Au contraire, la référence 11 décrit une magnétorésistance qui augmente avec le recuit, mais les propriétés obtenues ne permettent pas son utilisation dans des capteurs de champs faibles.

De plus, la réalisation de capteurs fabriqués à partir de ces structures connues ne peut avoir lieu que dans la mesure où celles-ci résistent à des températures allant de 150°C à 300°C. Dans le cas de structures NiFe/Cu (référence 5), des traitements thermiques à 150°C ont provoqué une diminution importante de la magnétorésistance sans modification notable du champ à saturation.

Il est donc nécessaire de trouver une nouvelle structure magnétique multicouche pour capteurs, capable de résister à des cycles thermiques pouvant aller jusqu'à 300°C.

Par ailleurs, certaines des structures multicouches connues (voir les références 4, 6, 8 et 11) présentent des champs coercitifs Hc trop élevés (supérieurs à 800 A/m, soit environ 10 Oe) pour être utilisés dans un capteur. D'autres structures (voir la référence 9) présentent soit une magnétorésistance trop faible, soit un champ à saturation trop élevé (références 4, 7 à 11), soit les deux ainsi qu'une perméabilité magnétique beaucoup trop faible (inférieure à 200). Le couplage anti-ferromagnétique qui apparaît entre les couches magnétiques a conduit jusqu'à présent à des champs à saturation Hs trop élevés.

L'invention a donc pour objet une structure magnétique multicouche ne présentant pas les inconvénients ci-dessus. En particulier, cette structure est utilisable dans un capteur magnétorésistif et présente de bonnes caractéristiques magnétiques qui ne se dégradent pas et même qui sont améliorées, lorsqu'elle est soumise à un recuit thermique supérieur à 150°C.

Aucune des structures multicouches actuellement connues et possédant des propriétés magnétiques acceptables ne voit ses propriétés magnétiques améliorées lorsqu'elles sont soumises à un tel recuit.

Pour obtenir une structure magnétique multicouche ne présentant pas les problèmes précédemment cités, il est nécessaire de limiter la miscibilité entre les couches magnétiques et non-magnétiques. En effet, l'épaisseur optimale de la couche non-magnétique conduisant au couplage anti-ferromagnétique étant très faible (de l'ordre du nm), il faut éviter l'apparition d'un fort couplage ferromagnétique direct entre les couches magnétiques, dû par exemple à la non-continuité des couches non-magnétiques ou au mélange chimique apparaissant aux températures atteintes lors de la fabrication du capteur utilisant cette structure.

Le principe utilisé dans l'invention est donc la non-miscibilité entre les couches métalliques non-magnétiques et les couches magnétiques.

A cet effet, l'invention a pour objet l'obtention d'une structure magnétique multicouche métallique, formée d'un empilement de couches en un matériau magnétique séparées par des couches en un matériau non-magnétique, le matériau magnétique étant un alliage choisi parmi les alliages FeNi, FeNiCo, NiCo et le matériau non-magnétique est l'argent.

La composition en fer de ces alliages est ≤50% en atome.

En particulier pour FeNi, on choisit un alliage ayant de 50 à 99% en atome de Ni et de 1 à 50% en atome de fer. De préférence, on utilise un alliage de FeNi ayant moins de 90% en atome de nickel. Typiquement, on utilise l'alliage $Fe_{19}Ni_{81}$.

Le nombre de couches magnétiques de la structure peut varier de 2 à 5000 selon l'application envisagée (type de capteur, guide de flux).

L'épaisseur de chaque couche magnétique peut varier de 0,5 à 50nm et de préférence de 1 à 2nm.

L'épaisseur des couches d'argent est avantageusement choisie de 0,5 à 5nm.

Les couches magnétiques et non-magnétiques sont déposées sur un substrat quelconque, par exemple en silicium mono- ou polycristallin, en arséniure de gallium, en verre, en plastique, en polymère et même en métal recouvert d'un isolant électrique.

L'invention a donc pour objet un procédé de fabrication d'une structure magnétique multicouche telle que décrite précédemment. Selon une caractéristique essentielle de ce procédé, les couches magnétiques et non-magnétiques sont déposées par condensation de vapeurs métalliques sur un substrat, à une température inférieure à la température ambiante. De préférence, on utilise la pulvérisation cathodique mais l'évaporation est utilisable.

Typiquement, le dépôt est effectué a une température de -196°C à -50°C et de préférence entre -196°C et -150°C.

Ce procédé permet une meilleure ségrégation entre les couches magnétiques et non-magnétiques et donc une non-miscibilité de ces couches.

Pour un dépôt effectué à une température égale ou supérieure à la température ambiante, on obtient des effets indésirables tels que la formation de petits grains de matériau magnétique dans l'argent ainsi que la non-conservation des discontinuités entre couches.

Les matériaux utilisés ainsi que le procédé de dépôt permettent d'obtenir des structures multicouches possédant d'excellentes propriétés magnétiques telles que :

- une magnétorésistance élevée, supérieure à 0,15,
- un champ à saturation faible, inférieur à 400 Oe (environ 32kA/m),
- une hystérésis quasi-nulle, inférieure à 1 Oe (environ 80 A/m),
- une réponse linéaire sur toute la gamme du champ magnétique jusqu'à H=Hs,
- une perméabilité magnétique élevée (supérieure à 200),

ceci à une température de 20°C environ.

La plupart des structures multicouches actuellement connues ne présentent pas toutes ces caractéristiques. Ainsi, la plupart des structures présentent une magnétorésistance trop faible ou un champ à saturation trop élevé telles que les structures décrites dans les références 4, 7 à 11. D'autres présentent une hystérésis trop élevée telles que celles des références 6 et 11.

Seule la structure $Fe_{19}Ni_{81}$/Cu de la référence 5 présente ces caractéristiques mais un recuit à une température de 150°C à 300°C nécessaire pour la fabrication d'un capteur en couche mince diminue ces performances.

Contrairement à tous les systèmes multicouches étudiés jusqu'à présent, les performances de la structure multicouche de l'invention sont bonnes et elles s'améliorent avec le recuit.

Ainsi, la magnétorésistance augmente jusqu'à une température critique comprise entre 150°C et 300°C à partir de laquelle elle diminue par la suite, cette température critique étant fonction de l'épaisseur des couches utilisées ; le champ à saturation diminue lorsque la température augmente ; et après le recuit, l'hystérésis reste faible (inférieure à 1 Oe), et la réponse linéaire est conservée.

Il apparaît, de plus, après recuit, une augmentation importante de la perméabilité, ce qui est particulièrement intéressant pour l'utilisation de cette structure dans un capteur.

Ainsi, de façon avantageuse, la structure magnétique est soumise à un recuit entre 150°C et 300°C. La température de recuit utilisée est fonction de l'épaisseur des différentes couches utilisées.

Les structures magnétiques ainsi obtenues sont intéressantes à la fois pour servir de magnétorésistances sensibles et perméables pour des capteurs ainsi que pour servir de guide de flux magnétique.

L'invention contribue ainsi à obtenir un capteur multicouche à effet magnétorésistif, comportant un empilement de couches en un matériau magnétique séparées par des couches en un matériau non-magnétique, le matériau magnétique étant un alliage choisi parmi les alliages FeNi, FeNiCo, NiCo et le matériau non-magnétique est l'argent.

D'autres caractéristiques et avantages de l'invention ressortiront mieux de la description qui va suivre, donnée à titre illustratif et non limitatif, en référence aux dessins annexés dans lesquels :

- la figure 1 représente schématiquement, en coupe longitudinale, une structure multicouche telle que fabriquée par le procédé conforme à l'invention,
- la figure 2 donne les variations de la sensibilité ΔR/R par MA/m de structures multicouches conformes à l'art antérieur et à l'invention en fonction de la température T, exprimée en °C,
- la figure 3 donne les variations de la magnétorésistance MR avant et après recuit d'une structure obtenue selon l'invention en fonction du champ magnétique H appliqué, exprimé en kA/m,
- la figure 4 donne les variations de la permabilité magnétique μ avant et après recuit d'une structure obtenue selon l'invention en fonction de la fréquence magnétique F appliquée, exprimée en MHz.

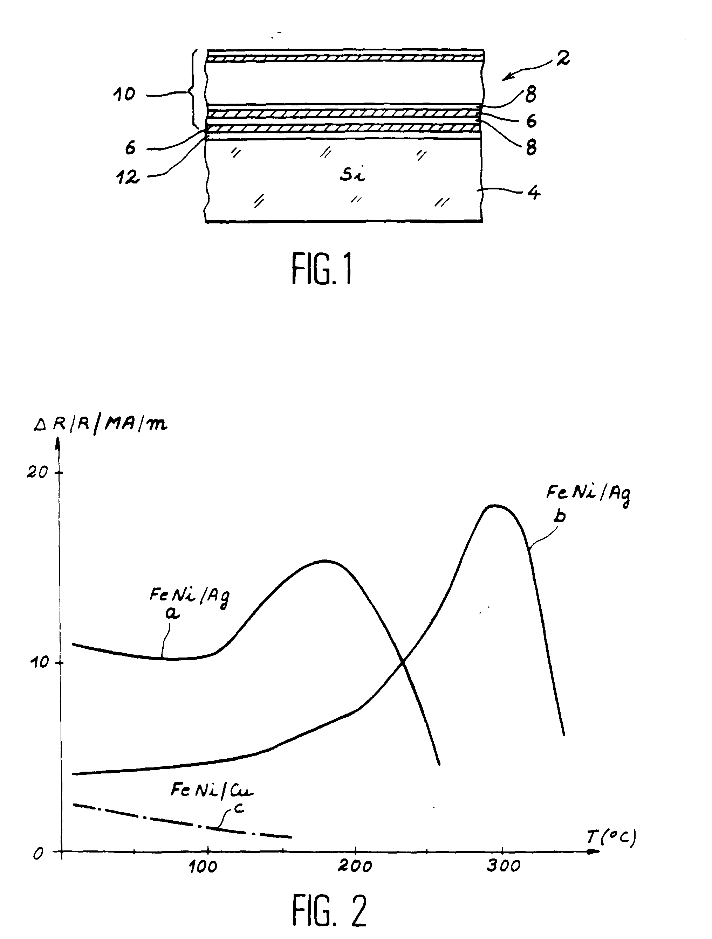

La référence 2 de la figure 1 indique de façon générale la structure magnétique multicouche conforme à l'invention. Cette structure comporte un substrat 4 en silicium sur lequel sont déposées en alternance des couches 6 d'argent et des couches 8 d'alliage FeNi, FeNiCo ou CoNi.

Une couche 12 d'accrochage magnétique (de Fe par exemple (références 6, 10)) ou non magnétique (de $SiO_2$ ou $Si_3N_4$) peut être avantageusement déposée sur le substrat 4 afin d'améliorer la qualité structurale de l'empilement.

Les couches conductrices 6 ont une épaisseur de 0,5 à 5nm et les couches magnétiques 8 une épaisseur typique de 1 à 2nm.

L'empilement 10 de couches magnétiques et non-magnétiques peut comporter de 2 à 5000 couches selon l'application envisagée. Pour une tête de lecture, on utilise par exemple 220 couches de FeNi de 1,2nm d'épaisseur chacune et 220 couches d'Ag de 1nm d'épaisseur chacune.

Conformément à l'invention, ces couches 6 et 8 sont déposées par pulvérisation cathodique, par exemple, en maintenant le substrat 4 à une température de -196°C à -50°C et par exemple entre -196°C et -150°C.

Les structures magnétiques obtenues selon l'invention présentent, contrairement à celles de l'art antérieur, une magnétorésistance élevée, une faible coercitivité (Hc faible) et une forte perméabilité après un recuit à une température inférieure à 300°C, cette température étant fonction de l'épaisseur des couches.

Ainsi, une étude a montré que pour un empilement de 200 couches constitué d'une alternance de couches de FeNi de 1,2nm d'épaisseur et d'argent de 1nm d'épaisseur, un recuit à 290°C conduisait à l'obtention d'un matériau doux présentant un champ magnétique coercitif Hc de 0,5 Oe (environ 40A/m), une forte sensibilité avec $\alpha=19$ par MA/m et une forte perméabilité magnétique avec $\mu=1500$, pour une fréquence de 1MHz.

A titre de comparaison, on donne sur la figure 2 une évolution de la sensibilité de différentes structures multicouches, obtenues selon l'invention et à l'art antérieur, en fonction de la température de recuit. Ces courbes donnent les variations de $\Delta R/R$ par MA/m en fonction de la température de recuit T donnée en °C. La sensibilité est mesurée après retour à la température ambiante.

La courbe $\underline{a}$ est relative à un empilement de $Fe_{19}Ni_{81}$/Ag de 200 couches respectivement de 1,6nm et 1,3nm. La courbe $\underline{b}$ est relative à un empilement de $Fe_{19}Ni_{81}$/Ag de 200 couches avec une épaisseur respective de 1,2nm et 1,1nm. La courbe $\underline{c}$ est relative à un empilement de $Fe_{19}Ni_{81}$/Cu de 200 couches avec des épaisseurs respectives de 1,5nm et 0,9nm (voir référence 5).

On constate que la sensibilité des structures obtenues selon l'invention croît avec la température de recuit jusqu'à une certaine valeur qui est fonction de l'épaisseur des couches respectivement magnétiques et non-magnétiques, contrairement à ce qui se passe pour les structures de l'art antérieur. Ainsi, le recuit, jusqu'à une certaine valeur, permet d'améliorer la sensibilité des structures obtenues selon l'invention.

L'influence de ce recuit thermique apparaît aussi dans le tableau ci-après qui donne la magnétorésistance $\Delta R/R$ et la valeur du champ magnétique à saturation Hs pour différentes températures de recuit et différents empilements.

On constate d'après ce tableau que la magnétorésistance décroît lorsque la température de recuit augmente pour des structures selon l'art antérieur alors qu'elle croît lorsque la température de recuit augmente pour des structures obtenues selon l'invention. En outre, la température de recuit ne modifie pratiquement pas le champ magnétique à saturation pour les matériaux de l'art antérieur alors qu'elle le diminue favorablement pour les structures de l'invention.

Ainsi, contrairement à toutes les structures multicouches connues, les structures FeNi/Ag, mais aussi FeNiCo/Ag et NiCo/Ag présentent des performances élevées qui s'améliorent après un recuit.

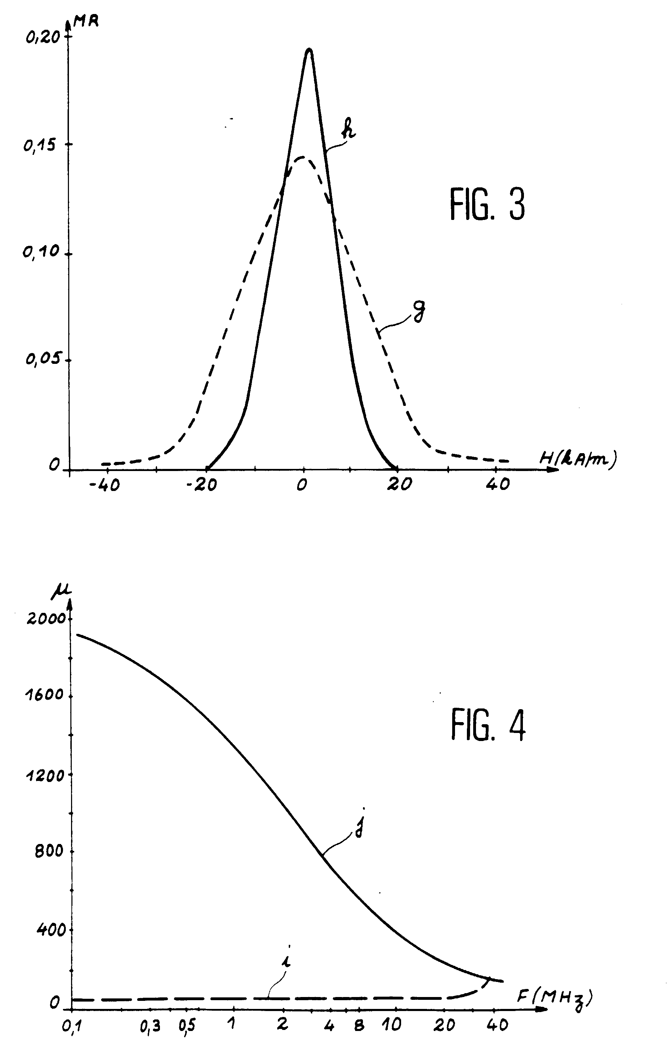

Ces résultats inattendus ressortent clairement de la figure 3 qui donne les variations de la magnétorésistance MR en fonction du champ magnétique appliqué, pour une structure en $Fe_{19}Ni_{81}$/Ag à 20°C conforme à l'exemple 1 ; les courbes $\underline{g}$ et $\underline{h}$ sont relatives aux variations de la magnétorésistance avant et après recuit à 250°C.

On constate encore sur ces courbes que le recuit permet une augmentation de la magnétorésistance et une diminution de la résistivité, une diminution du champ à saturation et une hystérésis toujours nulle ainsi qu'une linéarité conservée.

Cette amélioration des performances au recuit indique clairement que les couches d'argent ne se mélangent pas aux couches de FeNi. Il en est de même pour les structures NiCo/Ag et FeNiCo/Ag.

Une autre étude a permis de montrer que le recuit améliore de façon significative la perméabilité magnétique de la structure multicouche. En effet, avec une structure de 5μm d'épaisseur, des couches de FeNi de 1,2nm et d'argent de 1,1nm, on obtient une perméabilité magnétique du matériau brut μ après dépôt de 50 à la fréquence de 1MHz. Avec un recuit autour de 290°C, la perméabilité magnétique devient supérieure à 1500 pour un champ coercitif faible autour de 40 A/m (soit 0,5 Oe). Cet effet de couches douces magnétiques est très intéressant pour la réalisation de guides de flux magnétique et pour servir de magnétorésistances sensibles et perméables.

Ce résultat est confirmé par la figure 4 qui donne les variations de la perméabilité magnétique en fonction de la fréquence F exprimée en MHz du champ magnétique appliqué. Les courbes $\underline{i}$ et $\underline{j}$ sont relatives respectivement à la perméabilité magnétique obtenue avant et après recuit. La structure étudiée est la même que celle utilisée pour les courbes de la figure 3.

L'obtention d'une forte perméabilité magnétique permet une meilleure sensibilité des capteurs magnétorésistifs par un accroissement du flux magnétique capté.

Jusqu'à présent, personne n'avait envisagé l'emploi de structures FeNi/Ag, FeNiCo/Ag ou NiCo/Ag du fait que rien ne pouvait laisser prévoir leurs propriétés inattendues par comparaison aux autres structures multicouches.

De manière surprenante on observe déjà sur des capteurs magnétorésistifs non-optimisés des gains en signal supérieurs d'un facteur 10 par rapport à ceux réalisés avec les structures de l'art antérieur.

Ainsi, on a réalisé un capteur magnétorésistif en FeNi/Ag pour la lecture d'informations stockées sous la forme de domaines magnétiques dans un disque magnétique. Le capteur magnétorésistif mesurait 1mm de long, 7μm de large et 0,5μm d'épaisseur. Les couches de FeNi étaient des couches de $Fe_{19}Ni_{81}$ de 1,2nm d'épaisseur et les couches d'argent avaient une épaisseur de 1,1nm. La résistance du capteur en champ nul était de 73 ohms et la magnétorésistance totale (pour aller de H=0 à H=Hs) valait 10%. Le substrat était du silicium.

Des pistes magnétiques de 1,2mm de large ont été préalablement inscrites dans le disque avec une tête magnétique inductive.

Les propriétés du disque étaient les suivantes : le produit Mrδ valait 560 gaussxμm (45kA) avec Mr représentant l'aimantation rémanente et δ l'épaisseur du film magnétique et Hc valait 800 Oe (63A/m).

La largeur des domaines magnétiques était de 50 μm et la vitesse de défilement du disque de 0,2m/s.

Dans ces conditions, en utilisant un courant de 35 milliampères appliqués sur la magnétorésistance, soit une densité de courant de $10^6 A/cm^2$, un signal de 80 millivolts crête à crête a pu être obtenu.

Par ailleurs, avec la même structure magnétique que celle utilisée pour le capteur résistif, un guide de flux magnétique a été réalisé. Son aimantation à saturation était comprise entre 100 et 300 KA/m, sa perméabilité était de l'ordre de 1000 à une fréquence de 1MHz, l'hystérésis magnétique était inférieure à 1 Oe (79A/m).

Ainsi, il est possible de réaliser dans la même enceinte de dépôt, par pulvérisation cathodique à partir d'un même jeu de cibles, une magnétorésistance et un guide de flux qui concentre les lignes de champ magnétique dans cette magnétorésistance.

## TABLEAU

| | ECHANTILLONS | | | RECUIT | | | | | | | |
|---|---|---|---|---|---|---|---|---|---|---|---|
| | | | | 20°C | | 150°C | | 200°C | | 250°C | |
| | MATERIAU | EPAISSEUR DE COUCHES nm | NOMBRE DE COUCHES TOTAL | ΔR/R | Hs (kA/m) | ΔR/R | Hs (kA/m) | ΔR/R | Hs (kA/m) | ΔR/R | Hs (kA/m) |
| CONTRE-EXEMPLE | FeNi/Cu | 1,5 /0,9 | 14 | 0,105 | 45 | 0,036 | 45 | non effectué | non effectué | non effectué | non effectué |
| EXEMPLE | FeNi/Ag | 1,2 / 1,1 | 200 | 0,15 | 24 | 0,155 | 23 | 0,18 | 20 | 0,18 | 12 |

## Revendications

1. Procédé de fabrication d'une structure magnétique multicouche métallique comportant uniquement un empilement (10) de couches en un matériau magnétique (8) séparées par des couches en un matériau métallique non-magnétique (6) d'épaisseur telle qu'il s'établit un couplage anti-ferromagnétique entre les couches magnétiques, caractérisé en ce qu'on dépose les couches magnétiques (8) et non-magnétiques (6) par condensation de vapeurs métalliques sur un substrat (4) à une température inférieure à la température ambiante, ce matériau magnétique étant un alliage choisi parmi les alliages FeNi, FeNiCo et NiCo, et le matériau non-magnétique étant l'argent.

2. Procédé selon la revendication 1, caractérisé en ce que la technique de dépôt par condensation de vapeurs métalliques est la pulvérisation cathodique.

3. Procédé selon la revendication 1 ou 2, caractérisé en ce que le dépôt est effectué à une température allant de -196°C à -50°C.

4. Procédé selon l'une quelconque des revendications 1 à 3, caractérisé en ce que le dépôt est effectué à une température de -196°C à -150°C.

5. Procédé selon l'une quelconque des revendications 1 à 4, caractérisé en ce que l'empilement (10) est réalisé sur une couche d'accrochage (12) magnétique ou non magnétique, préalablement déposée sur le substrat.

6. Procédé selon l'une quelconque des revendications 1 à 5, caractérisé en ce que l'on effectue un recuit de l'empilement à une température allant de 150°C à 300°C.

## Patentansprüche

1. Verfahren zur Herstellung einer metallischen magnetischen Mehrschichtstruktur mit nur einem Stapel (10) aus Schichten eines magnetischen Materials (8), getrennt durch Schichten aus einem metallischen nichtmagnetischen Material (6) von derartiger Dicke, daß sich zwischen den magnetischen Schichten eine antiferromagnetische Kopplung aufbaut,
**dadurch gekennzeichnet**
daß man die magnetischen (8) und nichtmagnetischen (6) Schichten durch Kondensation von metallischen Dämpfen auf einem Substrat (4) bei einer niedrigeren Temperatur als der Umgebungstemperatur abscheidet, dieses magnetische Material eine unter den Legierungen FeNi, FeNiCo und NiCo ausgewählte Legierung ist und das nichtmagnetische Material Silber ist.

2. Verfahren nach Anspruch 1, dadurch gekennzeichnet, daß die Technik der Kondensation mittels Abscheidens metallischer Dämpfe Kathodenzerstäubung bzw. Sputtern ist.

3. Verfahren nach Anspruch 1 oder 2, dadurch gekennzeichnet, daß die Abscheidung bei einer Temperatur von -196°C bis -50°C durchgeführt wird.

4. Verfahren nach einem der Ansprüche 1 bis 3, dadurch gekennzeichnet, daß die Abscheidung bei einer Temperatur von -196°C bis -150°C durchgeführt wird.

5. Verfahren nach einem der Ansprüche 1 bis 4, dadurch gekennzeichnet, daß der Stapel (10) auf einer vorher auf das Substrat aufgebrachten magnetischen oder nichtmagnetischen Haftschicht (12) abgeschieden wird.

6. Verfahren nach einem der Ansprüche 1 bis 5, dadurch gekennzeichnet, daß man ein Tempern des Stapels mit einer von 150°C bis 300°C gehenden Temperatur durchführt.

## Claims

1. Process for the production of a multilayer metallic magnetic structure having only one stack (10) of magnetic material layers (8) separated by metallic, non-magnetic material layers (6) with a thickness such that there is an anti-ferromagnetic coupling between the magnetic layers, characterized in that the magnetic (8) and non-magnetic (6) layers are deposited by the condensation of metal vapours on a substrate (4) at a temperature below ambient temperature, said magnetic material being an alloy chosen from among FeNi, FeNiCo and NiCo and the non-magnetic material is silver.

2. Process according to claim 1, characterized in that the metal vapour condensation deposition method is cathodic sputtering.

3. Process according to claim 1 or 2, characterized in that the deposit is made at a temperature from -196 to -50°C.

4. Process according to any one of the claims 1 to 3, characterized in that the deposit is made at a temperature of -196 to -150°C.

5. Process according to any one of the claims 1 to 4, characterized in that the stack (10) is produced on a magnetic or non-magnetic attachment layer (12) previously deposited on the substrate.

6. Process according to any one of the claims 1 to 5, characterized in that the stack is annealed at a temperature from 150 to 300°C.

FIG.1

FIG. 2

FIG. 3

FIG. 4